# EUROPEAN PATENT SPECIFICATION

(11) **EP 0 267 036 B1**
(45) Date of publication and mention of the grant of the patent: **23.02.1994**
(21) Application number: 87309799.2
(22) Date of filing: 05.11.1987
(51) Int. Cl.: H01S 3/085, G11B 7/125, G01L 1/24, H01S 3/133

(54) **Waveguide type optical head**
Optischer Messfühlerkopf vom Wellenleitertyp
Tête de capteur optique du type guide d'ondes

(30) Priority: 05.11.1986 JP 264308/86
(43) Date of publication of application: 11.05.1988
(73) Proprietor: SHARP KABUSHIKI KAISHA, Osaka 545 (JP)
(72) Inventor: Yamamoto, Osamu, Nara-shi, Nara-ken (JP); Hayashi, Hiroshi, Soraku-gun, Kyoto-fu (JP); Miyauchi,Nobuyuki, Tenri-shi, Nara-ken (JP); Maei, Shigeki, Yamatokoriyama-shi, Nara-ken (JP); Kawanishi,Hidenori, Higashiosaka-shi, Osaka-fu (JP)
(74) Representative: Brown, Kenneth Richard

(56) References cited:
- EP-A- 0 174 008
- EP-A- 0 206 745
- DE-A- 3 632 229
- JP-A- 5 645 091
- US-A- 4 529 876
- PATENT ABSTRACTS OF JAPAN, vol. 7, no. 218 (E-200) (1363) 28th September 1983; & JP-A-58 111 391
- PATENT ABSTRACTS OF JAPAN, vol. 10, no. 60 (P-435)(2117) 11 March 1986; & JP-A-60 202 553
- IBM DISCLOSURE BULLETIN, vol. 24, no. 2, July 1981, pages 893-894; K. Korth: "Integrated optical force and stress sensor".
- JAPANESE JOURNAL OF APPLIED PHYSICS, 26 (1987), No. 5, 590

## Description

The present invention relates to optical sensor heads and optical pickups for use in optical measurement, optical information processing and various other fields.

With the development of higher output, more reliable semiconductor lasers and more accurate and lighter optical components in recent years, various optical sensors and optical disc devices such as compact discs and laser discs have been put to practical use for optical measurement and optical information processing using laser beams. A waveguide type optical head for smaller and lighter systems has been proposed and has drawn attention.

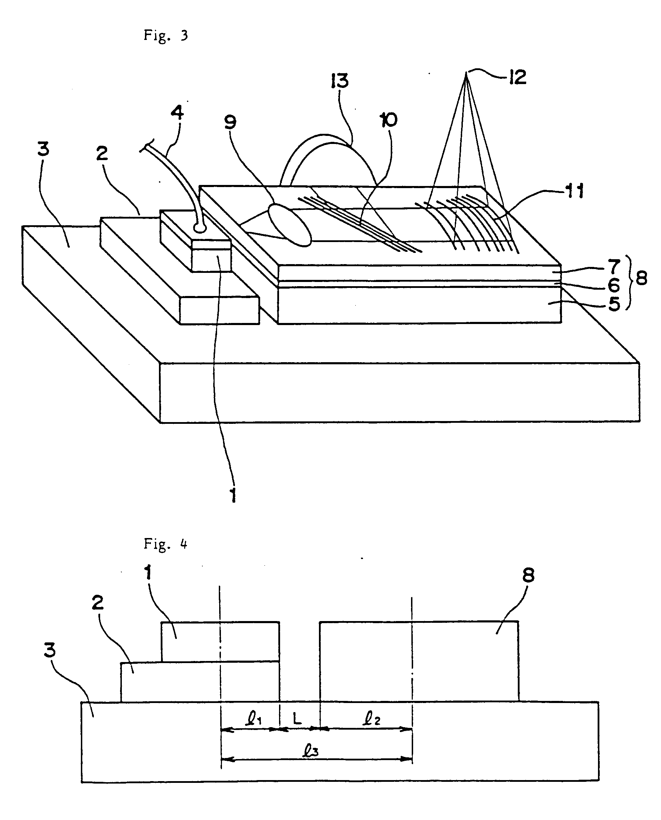

Fig. 3 shows the basic construction of a conventional optical head proposed as an optical pickup for optical discs. A semiconductor laser 1 is secured on a submount 2 made of, say, copper. The submount 2 is fixed on a metal mount 3. Current flow between an Au wire 4 and the mount 3 causes the semiconductor laser 1 to emit laser beams. A thin film waveguide element 8, composed of a silicon substrate 5, a SiO₂ buffer layer 6 formed by oxidation on the silicon substrate 5 and a glass waveguide layer 7 formed by sputtering on the buffer layer 6, is also fixed on the mount 3. On the waveguide layer 7 are formed a collimator lens 9, a beam splitter 10 and a focus grating coupler 11. A light beam emitted by the semiconductor laser 1 enters the waveguide layer 7 from one of the end faces thereof, is made parallel by the collimator lens 9 and concentrated by the focus grating coupler 11 as a spot 12 on a disc surface. Light reflected from the spot 12 returns through the focus grating coupler 11 into the waveguide and is redirected by the beam splitter 10 to an optical sensor 13 located on one side of the waveguide so that information recorded on the disc is read.

The collimator lens 9, the beam splitter 10 and the focus grating coupler 11 are susceptible to wavelength variation in the light source; the angle of refraction changes with wavelength, causing the focal point 12 to deviate widely from the setting. Since an ordinary semiconductor laser emits a laser beam of oscillation wavelength which changes continuously or intermittently with the driving current and/or room temperature, the proposed conventional optical head is not suitable as an optical pickup.

Furthermore, the light reflected from the end face of the waveguide (made up of glass, SiO₂ and Si substrate) returns to the semiconductor laser, causing the oscillation wavelength of the semiconductor laser to change because the laser beam reflected back from the end face of the waveguide to the semiconductor laser generates a composite resonator effect realized by three reflection surfaces; the waveguide end face and the two end faces of the semiconductor laser resonator. The oscillation wavelength is selected by this composite resonator effect. However, since the wavelength to be selected changes with room temperature and driving current, the oscillation wavelength varies with these conditions.

Wavelength selection in conventional optical heads with mounts made of copper or the like metal is described in detail with reference to Fig. 4.

Fig. 4 is a side view of the waveguide type optical head shown in Fig. 3. Assuming the lengths of the semiconductor laser 1 and the waveguide element 8 are 2ℓ₁ and 2ℓ₂, respectively, and the distance from the center of the semiconductor laser 1 to the centre of the waveguide element 8 is ℓ₃, the distance L from the end of the semiconductor laser 1 to the end of the waveguide element 8 is calculated by the following equation:

$\text{L = ℓ₃ - (ℓ₁ + ℓ₂) (1)}$

The thermal expansion coefficient for the distance L is obtained from the following formula: 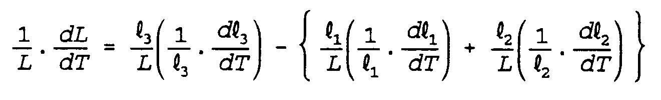
substituting $\text{ℓ₃ = L + ℓ₁ + ℓ₂}$ gives: 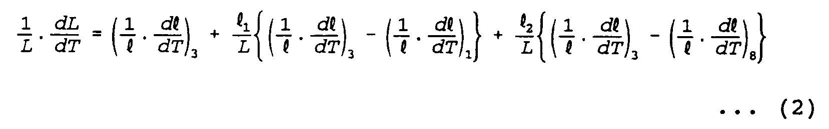
The term 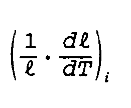
(i = 1, 3, 8) represents the thermal expansion coefficient of the semiconductor laser 1, the mount 3 or the waveguide element 8 respectively. For the proposed conventional head, the coefficient for the mount 3, 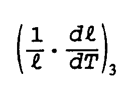
is 17.0 x 10⁻⁶ as it is made of copper, the coefficient for the semiconductor laser 1, 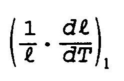
is 5.9 x 10⁻⁶ as it is made of GaAs-GaAlAs, and the coefficient for the waveguide element 8, 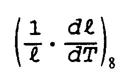
is 2.4 x 10⁻⁶ as it has a Si substrate. Normally, ℓ₁ is 100 to 200 µm, ℓ₂ is about 5 mm, and L is 5 to 50 µm. Therefore, since the second and third terms have large values, the thermal expansion coefficient for the distance L calculated by expression (2) becomes very large when the room temperature changes. Minor room temperature variation results in changed construction of the composite resonator, causing the oscillation wavelength of the semiconductor laser to vary.

It is an aim of the present invention to overcome at least some of the aforementioned problems, and in particular, to suppress the oscillation wavelength variation of the semiconductor laser.

According to one aspect of the present invention, there is provided a sensor device comprising a substrate formed of a semiconductor or dielectric substance and having a main surface, a thin film waveguide formed of a semiconductor or dielectric material disposed on the main surface of said substrate, and a semiconductor laser positioned adjacent to an incident end surface of said thin film waveguide and spaced therefrom by a distance sufficiently small so as to emit an input laser beam into said thin film waveguide, part of said input laser beam being reflected back toward the semiconductor laser by said incident end surface of said film waveguide so as to affect said emitted laser beam, the device further comprising means for detecting variations in a parameter of an output laser beam leaving said thin film waveguide, characterised in that said semiconductor laser is disposed on said substrate whereby, since said semiconductor laser and said waveguide element are both disposed on the main surface of said substrate, changes in distance between said semiconductor laser and said film waveguide due to thermal expansion are suppressed, resulting in a stable oscillation wavelength of said laser beam.

The semiconductor laser may be formed by epitaxial growth on the semiconductor or dielectric substrate.

In one embodiment the sensor device is an optical reading head, an optical system being formed on said thin film waveguide for projecting and focusing the input laser beam onto an optical memory medium and for directing reflected laser light from said medium toward said detecting means. More generally, an optical element disposed on the thin film waveguide has an optical processing function, such as polarization, optical selection, optical branching, optical composition, optical detection, lens or optical modulation.

In the sensor device of the present invention, the light beam reflected from the thin film waveguide end face is returned to the semiconductor laser element to select the oscillation wavelength. With the semiconductor laser and the thin film waveguide being provided on the same semiconductor substrate, changes in the distance between the semiconductor laser and the thin film waveguide are minimized, thereby stabilizing the oscillation wavelength.

According to a second aspect of the invention there is provided a waveguide type optical head, comprising:
a thin film waveguide disposed on said main surface;
an optical element having an optical signal processing function disposed on said thin film waveguide; and
a semiconductor laser disposed on said main surface and spaced from the waveguide by a distance sufficiently small for emitting a laser beam into said thin film waveguide element to produce an oscillating signal, and part of said laser beam being reflected by an incident end surface of said thin film waveguide and returned to said semiconductor laser.

According to the present invention, as described above, since the oscillation wavelength of the semiconductor laser is stabilized, it is possible to obtain a waveguide type head of high quality.

In order that the present invention may become more fully understood a detailed description is given hereinbelow of embodiments thereof, by way of example, with reference to the accompanying drawings wherein:
Figs. 1 and 2 show embodiments of the present invention;
Fig. 3 is a schematic drawing of the conventional waveguide type pickup; and
Fig. 4 is a diagrammatic side view of the device of Fig. 3 showing the distance between the semiconductor laser and the waveguide element.

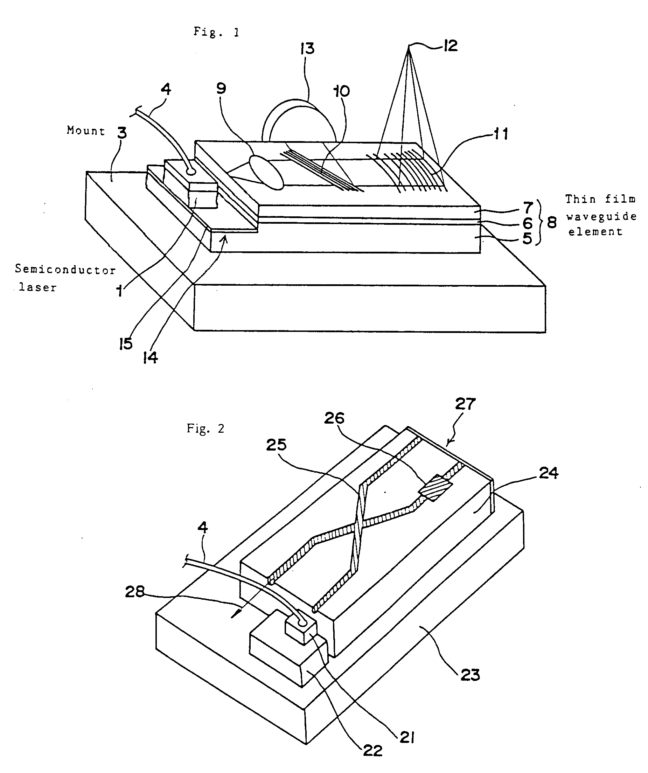

Fig. 1 is a perspective view of a first embodiment of the present invention. The parts with the same functions as those shown in Fig. 3 are allocated the same reference numbers.

A SiO₂ buffer layer 6 is formed by oxidation on a Si substrate 5, and a glass waveguide layer 7 is formed by sputtering on the buffer layer 6. A step 14 is formed at one end of the Si substrate 5 by using hydrofluoric acid series etchant and nitric acid series etchant. A collimator lens 9, a beam splitter 10 and a focus grating coupler 11 are formed on the waveguide 7. Here, the collimator lens 9 may be a geodesic lens obtained by forming a round recess in the waveguide 7. The beam splitter 10 for reflecting part of the laser beam is realized by providing oblique grating on the waveguide. The focus grating coupler 11 is realized by drawing with electron beam so-called chirped gratings which are curved and arranged with gradually changing intervals, on a resist film applied on the glass waveguide layer 7, as reported in the Extended Abstracts of the 30th Spring Meeting of the Japan Society of Applied Physics and Related Societies (1983) 4P-J-6. The focal length of the thus obtained focus grating coupler 11 is about 3mm.

Au and In are sequentially deposited by electron beam on the step 14 of the Si substrate 5 to form a fusion layer 15 on which the semiconductor laser 1 is fixed. The waveguide type optical pickup element thus obtained is secured on a mount 3. The semiconductor laser 1 emits a laser beam when current is allowed to flow between the Au wire 4 and the mount 3.

Similarly to the case of the convention optical head shown in Fig. 3, a light beam emitted by the semiconductor laser 1 enters the waveguide 7 from one end thereof, is made parallel by the collimator lens 9 and concentrated by the focus grating coupler 11 as a spot 12 on a disc surface. Light reflected from the spot 12 returns through the focus grating coupler 11 into the waveguide and is redirected by the beam splitter 10 to an optical sensor 13 located on one side of the waveguide whereby information recorded on the disc is read. If the optical sensor 13 is of split type it is possible to detect a focusing error signal and a tracking error signal, and to fix the focal point on the disc by moving the mount 3 by an actuator.

Since the semiconductor laser 1 and the waveguide element 8 are both formed on the Si substrate 5, 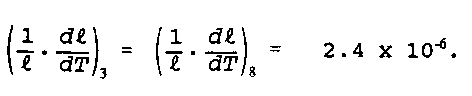
Accordingly, the third term of the expression (2) for the thermal expansion coefficient for the distance L between the semiconductor laser end and the waveguide end will obviously take a very small value approaching zero, resulting in a small thermal expansion coefficient for L. Part of the laser beam emitted by the semiconductor laser 1 is reflected by the end face of the waveguide element and returned to the semiconductor laser 1 for wavelength selection while variation in the distance L is suppressed. Consequently, the laser beam maintains a stable oscillation wavelength.

Needless to say, the wavelength selectivity can be improved by forming a highly reflective film on the incident end surface of the waveguide, taking care that light output from the focal point 12 does not interfere with the operation of the optical pickup. Alternatively, after GaP/GaAsP distortion super structure and GaAsP/GaAs distortion super structure are grown by MOCVD method on the step 14 of the Si substrate 5, a double hetero semiconductor laser of GaAs may be formed integrally on the super structures, as described in the Extended Abstracts of the 46th Autumn Meeting of the Japan Society of Applied Physics (1985) 3P-E-16. In this case, a resonator can be obtained by etching the semiconductor laser end surface by chemical etching or RIE (re-active ion etching) technique.

Si substrate is used in the above embodiment although GaAs or other semiconducting material can provide the same effect.

Fig. 2 shows another embodiment of the present invention. A mount 23 comprises a Si substrate. An interference type pressure sensor element 24 made of dielectric LiNbO₃ is fixed on the mount 23. A dielectric waveguide 25 of X shape is formed by Ti diffusion on the LiNbO₃ substrate 24. A highly reflective film 27 is formed on one end face of the LiNbO₃. A semiconductor laser 21 is fixed on the Si substrate (mount) 23 via a silicon submount 22. Part of a laser beam emitted by the semiconductor laser 21 enters the waveguide 25 while part of the laser beam is reflected by the waveguide end surface and returned to the semiconductor laser.

In the second embodiment as well, the semiconductor laser 21 and the waveguide 25 are formed on the same mount 23 so that change in the distance from the semiconductor laser 21 to the waveguide 25 is minimized, resulting in stable oscillation wavelength.

The waveguide 25 of X shape serves as a Michelson interferometer and generates interference output 28. When pressure is applied to a specified part 26 of the waveguide 25, the phase of the guided light is changed due to the photoelasticity effect. The phase variation is detected in terms of change in the interference output 28. Since pressure is detected on the basis of the interference of the phase of the guided light, wavelength change of the light source has a serious adverse effect on the detection accuracy of the sensor. According to the second embodiment of the present invention, wavelength change of the light source is minimized so that a sensor for accurate detection can be realized.

While only certain embodiments of the present invention have been described, it will be apparent to those skilled in the art that various changes and modifications may be made therein without departing from the scope of the present invention as claimed.

## Claims

1. A sensor device comprising a substrate (5,23) formed of a semiconductor or dielectric substance and having a main surface, a thin film waveguide (8,25) formed of a semiconductor or dielectric material (6,25) disposed on the main surface of said substrate, and a semiconductor laser (1,21) positioned adjacent to an incident end surface of said thin film waveguide and spaced therefrom by a distance sufficiently small so as to emit an input laser beam into said thin film waveguide, part of said input laser beam being reflected back toward the semiconductor laser by said incident end surface of said film waveguide so as to affect said emitted laser beam, the device further comprising means (13) for detecting variations in a parameter of an output laser beam leaving said thin film waveguide, characterised in that said semiconductor laser is disposed on said substrate whereby, since said semiconductor laser and said waveguide element are both disposed on the main surface of said substrate, changes in distance between said semiconductor laser and said film waveguide due to thermal expansion are suppressed, resulting in a stable oscillation wavelength of said laser beam.

2. A sensor device according to claim 1 in the form of an optical reading head, an optical system (9,10,11) being formed on said thin film waveguide for projecting and focusing the input laser beam onto an optical memory medium and for directing reflected laser light from said medium toward said detecting means (13).

3. A sensor device according to claim 1 in the form of a pressure detector, said thin film waveguide carrying a pressure-sensitive element (26) for creating a detectable variation in the output laser beam (28) in accordance with pressure applied to said pressure-sensitive element.

4. A sensor device according to claim 3, further characterised in that said thin film waveguide has a reflective end face (27) at the end opposite said incident end surface.

5. A waveguide type optical head, comprising:
a substrate formed of at least one of a semiconductor and dielectric substance having a main surface;
a thin film waveguide disposed on said main surface;
an optical element having an optical signal processing function disposed on said thin film waveguide; and
a semiconductor laser disposed on said main surface and spaced from the waveguide by a distance sufficiently small for emitting a laser beam into said thin film waveguide element to produce an oscillating signal, and part of said laser beam being reflected by an incident end surface of said thin film waveguide and returned to said semiconductor laser.

6. A waveguide type optical head according to claim 5, wherein said substrate is formed of at least one of Si, GaAs or LiNbO₃.

## Patentansprüche

1. Sensoreinrichtung mit einem Substrat (5, 23), das aus einer Halbleiter- oder Dielektrikum-Substanz gebildet ist und eine Hauptfläche besitzt, wobei ein dünnschichtiger Wellenleiter (8, 25) auf einem Halbleiter- oder Dielektrikum-Material (6, 25) gebildet ist, das auf der Hauptfläche des Substrats angeordnet ist, und mit einem Halbleiterlaser (1, 21), der neben einer Einfallsendfläche des Dünnschicht-Wellenleiters angeordnet und von dieser eine Distanz beabstandet ist, die hinreichend klein ist, um einen Eingabe-Laserstrahl in den Dünnschicht-Wellenleiter auszusenden, wobei ein Teil des Eingabe-Laserstrahls zurück zu dem Halbleiterlaser von der Einfallsendfläche des Schichtwellenleiters reflektiert wird, um den ausgesendeten Laserstrahl zu beeinflussen, wobei die Einrichtung ferner Mittel (13) zum Erkennen von Veränderungen in einem Parameter eines Ausgabe-Laserstrahls aufweist, der den Dünnschicht-Wellenleiter verläßt, **dadurch gekennzeichnet**, daß der Halbleiterlaser auf dem Substrat angeordnet ist, wodurch aufgrund der Tatsache, daß der Halbleiterlaser und das Wellenleiter-Element beide auf der Hauptfläche des Substrats angeordnet sind, Veränderungen in dem Abstand zwischen dem Halbleiterlaser und dem Schicht-Wellenleiter, die auf eine thermische Ausdehnung zurückgehen, unterdrückt werden, was dazu führt, daß der Laserstrahl eine stabile Schwingungswellenlänge besitzt.

2. Sensoreinrichtung nach Anspruch 1 in Form eines optischen Lesekopfes, wobei ein optisches System (9, 10, 11) auf dem Dünnschicht-Wellenleiter gebildet ist, um den Eingabe-Laserstrahl auf ein optisches Speichermedium zu richten und zu fokussieren, und um das reflektierte Laserlicht von dem Medium in Richtung auf das Erkennungsmittel (13) zu lenken.

3. Sensoreinrichtung nach Anspruch 1 in Form eines Druckdetektors, wobei der Dünnschicht-Wellenleiter ein druckempfindliches Element (26) zur Schaffung einer erkennbaren Veränderung in dem Ausgabelaserstrahl (28) gemäß dem auf das druckempfindliche Element angelegten Druck trägt.

4. Sensoreinrichtung nach Anspruch 3, ferner **dadurch gekennzeichnet**, daß der Dünnschicht-Wellenleiter eine reflektierende Endfläche (27) an dem Ende besitzt, die der Einfallsendfläche gegenüberliegt.

5. Optischer Kopf vom Typ Wellenleiter mit:
einem Substrat, das auf mindestens einer halbleitenden und dielektrischen Substanz gebildet ist, die eine Hauptfläche besitzt;
einem Dünnschicht-Wellenleiter, der auf der Hauptfläche angeordnet ist;
einem optischen Element, das eine optische Signalverarbeitungsfunktion besitzt und das auf dem Dünnschicht-Wellenleiter angeordnet ist; und
einem Halbleiterlaser auf der Hauptfläche und in einem Abstand vom Wellenleiter, der hinreichend klein ist, so daß ein Laserstrahl in das Dünnschicht-Wellenleiterelement ausgesendet wird, um ein Schwingungssignal zu erzeugen, und wobei ein Teil des Laserstrahls von einer Einfallsendfläche des Dünnschicht-Wellenleiters reflektiert und zu dem Halbleiterlaser zurückgeleitet wird.

6. Optischer Kopf vom Wellenleitertyp gemäß Anspruch 5, wobei das Substrat zumindest aus Si, GaAs oder LiNbO₃ gebildet ist.

## Revendications

1. Dispositif détecteur comprenant un substrat (5, 23) formé d'une substance semi-conductrice ou diélectrique et présentant une surface principale, un guide d'ondes à film fin (8, 25) formé en un matériau semi-conducteur ou diélectrique (6, 25) disposé sur la surface principale dudit substrat et un laser à semi-conducteur (1, 21) positionné dans le voisinage d'une surface d'extrémité incidente dudit guide d'ondes à film fin et distant de celle-ci d'une distance suffisamment réduite de manière à émettre un faisceau laser d'entrée dans ledit guide d'ondes à film fin, une partie dudit faisceau laser d'entrée étant réfléchie vers le laser à semi-conducteur par ladite surface d'extrémité incidente dudit guide d'ondes à film fin, de manière à affecter ledit faisceau laser émis, le dispositif comprenant, en outre, un moyen (13) pour détecter les variations d'un paramètre d'un faisceau laser de sortie partant dudit guide d'ondes à film fin, caractérisé en ce que ledit laser à semi-conducteur est disposé sur ledit substrat, les modifications de la distance entre ledit laser à semi-conducteur et ledit guide d'ondes à film dues à la dilatation thermique étant supprimées du fait que ledit laser à semi-conducteur et ledit élément guide d'ondes sont tous deux disposés sur la surface principale dudit substrat, ce qui a pour résultant une longueur d'onde d'oscillation stable dudit faisceau laser.

2. Dispositif détecteur suivant la revendication 1, sous forme de tête de lecture optique, un système optique (9, 10, 11) étant formé sur ledit guide d'ondes à film fin pour projeter et concentrer le faisceau laser d'entrée sur un milieu de mémoire optique et pour diriger la lumière laser réfléchie dudit milieu vers ledit moyen de détection (13).

3. Dispositif détecteur suivant la revendication 1, sous forme d'un détecteur de pression, ledit guide d'ondes à film fin portant un élément sensible à la pression (26) destiné à créer une variation détectable dans le faisceau laser de sortie (28) selon la pression appliquée sur ledit élément sensible à la pression.

4. Dispositif détecteur suivant la revendication 3, caractérisé, en outre, en ce que ledit guide d'ondes à film fin présente une face d'extrémité réfléchissante (27) à l'extrémité opposée à ladite surface d'extrémité incidente.

5. Tête optique du type guide d'ondes, comprenant : un substrat formé d'au moins une substance semi-conductrice et diélectrique présentant une surface principale, un guide d'ondes à film fin disposé sur ladite surface principale, un élément optique ayant une fonction de traitement des signaux optiques, disposé sur ledit guide d'ondes à film fin, et un laser à semi-conducteur disposé sur ladite surface principale et distant du guide d'ondes d'une distance suffisamment réduite pour émettre un faisceau laser dans ledit élément guide d'ondes à film fin pour produire un signal d'oscillation, et une partie dudit faisceau laser étant réfléchie par une surface d'extrémité incidente dudit guide d'ondes à film fin et retournée vers ledit laser à semi-conducteur.

6. Tête optique du type guide d'ondes suivant la revendication 5, dans laquelle ledit substrat est formé d'au moins un parmi Si, GaAs ou LiNbO₃.
